# EUROPÄISCHE PATENTSCHRIFT

(11) **EP 1 252 647 B1**
(45) Veröffentlichungstag und Bekanntmachung des Hinweises auf die Patenterteilung: **26.09.2007**
(21) Anmeldenummer: 01902303.5
(22) Anmeldetag: 11.01.2001
(51) Int. Cl.: H01J 37/32

(54) **EINKOPPELANORDNUNG FÜR MIKROWELLENENERGIE MIT IMPEDANZANPASSUNG**
IMPEDANCE ADAPTED MICROWAVE ENERGY COUPLING DEVICE
DISPOSITIF D'INJECTION D'ENERGIE MICRO-ONDES AVEC ADAPTATION D'IMPEDANCE

(30) Priorität: 19.01.2000 DE 10001936
(43) Veröffentlichungstag der Anmeldung: 30.10.2002
(73) Patentinhaber: Tetra Laval Holdings & Finance SA, 1009 Pully (CH)
(72) Erfinder: MOORE, Rodney, Gardener, MA 01440 (US); KÄSS, Hanno, 64287 Darmstadt (DE); ESSERS, Wolf, 64331 Weiterstadt (DE)
(74) Vertreter: Weber, Roland
(86) Internationale Anmeldenummer: PCT/EP2001/000257
(87) Internationale Veröffentlichungsnummer: WO 2001/054164

(56) Entgegenhaltungen:
- WO-A-97/44503
- WO-A-99/17334
- DE-A- 3 632 748
- US-A- 4 434 742

## Beschreibung

Die Erfindung betrifft eine Anordnung zum Einkoppeln von Mikrowellenenergie in einen Hohlkörper, welcher die Behandlungskammer bildet, insbesondere eine Plasma-CVD-Beschichtungskammer für die Beschichtung der Innenwand eines Hohlkörpers, mit einer Mikrowellenquelle, einer Mikrowelleneinkoppeleinrichtung, einem Mikrowellenleiter und einem Gaszuführrohr, durch welches Prozeßgas in den Hohlkörpers einführbar und durch die eingekoppelte Mikrowellenenergie in den Plasmazustand aktivierbar ist und welches sich von einer ersten Seite koaxial in den Hohlkörper erstreckt, während sich die Mikrowelleneinkoppeleinrichtung auf der gegenüberliegenden zweiten Seite befindet.

Bei der Beschichtung von Hohlkörpern, insbesondere von Kunststoffflaschen, werden diese in einer Beschichtungskammer dem Plasma eines Prozeßgases ausgesetzt. Die Qualität der Beschichtung hängt unter anderem von der Impedanz des Systems für die eingestrahlte Mikrowellenenergie ab. Wenn sich hinsichtlich der Mikrowelleneinstrahlung oder Impedanz Veränderungen einstellen, haben die Hohlkörper Beschichtungen unterschiedlicher Qualität und Dicke. Man hat daher versucht, eine Koppelanordnung mit einer elektrisch stabilen Abstimmung einzurichten, wobei auch absorbierende oder streuende Bauteile der Koppelanordnung berücksichtigt wurden.

Bei einer Koppelanordnung nach der WO 99/17334 wird die Mikrowellenenergie von der Mikrowellenquelle über einen geraden Mikrowellenleiter in die Beschichtungskammer eingekoppelt, bei welcher der zylinderförmige Mikrowellenleiter mittig in einer Vakuumkammer angeordnet ist. Dadurch ergeben sich feste elektrische Verhältnisse.

Es hat sich gezeigt, daß sich bei der Behandlung unterschiedlicher Hohlkörper, d.h. unterschiedlicher Gestaltungen derselben und insbesondere bei Hohlkörpern verschiedener Größe und wechselnder Formen Impedanzänderungen ergeben. Wenn zuerst eine erste Form und Größe von Hohlkörpern behandelt wurde und danach eine zweite andere Form und Größe beschichtet werden soll, ist es schwierig, die Mikrowellenenergie in gleicher Weise in Bereiche zu konzentrieren, wo sie für die Aktivierung des Prozeßgases in den Plasmazustand gewünscht ist. Selbstverständlich ist es möglich, durch andere Gestaltungen von Mikrowellenleitern die richtige Anpassung zu erreichen und die betrachtete Impedanz von einer Charge auf die andere entsprechend gleich zu halten. Der Wechsel auf andere Mikrowellenleiter erfordert aber einen großen Aufwand. Die bekannte Mikrowellenkammer sollte der Gestalt des zu beschichtenden Hohlkörpers möglichst nahe kommen, zum Beispiel zylinderförmig sein.

Für gute Anpassungen kann man Magnete an der Beschichtungskammer anordnen, um das Plasma an die richtigen Stellen in dem Hohlkörper zu konzentrieren. Die Lagerhaltung, Anordnung und Befestigung einer Vielzahl von Magneten ist aber umständlich, und die Magnete erfahren selbst eine Beschichtung, wenn sie an der effektivsten Stelle angeordnet werden, nämlich in der Behandlungskammer.

Die WO 99/17334 offenbart nicht einen zusätzlichen, elektrisch leitenden, zylindermantelförmigen Hohlleitereinsatz. Außerdem weist das Gaszuführrohr nicht elektrisch leitendes Material auf.

Aus der DE 36 32 748 A1 ist ein Verfahren zur Beschichtung von Hohlkörpern mit polymeren Deckschichten bekannt. Es sollte ermöglicht werden, Hohlkörper aus Kunststoffen oder anderen nichtmikrowellenaktiven Materialien, zum Beispiel Glas, mit diffusionshemmenden Schichten zu versehen. Die Gaseinleitungseinrichtung ist für die Durchführung dieses bekannten Verfahrens eine mikrowellenmäßig abgeschirmte Düse. Nachdem der Hohlkörper und die Vakuumkammer auf den notwendigen Arbeitsdruck evakuiert sind, muß von außen an mehreren Stellen Mikrowellenenergie in die Vakuumkammer eingespeist werden. Es sind also mindestens zwei Einkopplungsanordnungen notwendig, wobei die Mittelachsen der Einkoppelleitungen sich kreuzen oder parallel zueinander liegen. Außerdem hat man festgestellt, daß für die Schaffung eines homogenen elektrischen Feldes in der Vakuumkammer zusätzliche Maßnahmen vorgesehen werden müssen.

Der Erfindung liegt daher die Aufgabe zugrunde, eine Einkoppelanordnung der eingangs genannten Art zu schaffen, mit deren Hilfe Hohlkörper unterschiedlicher Gestalt und Größe mit geringerem Umrüstaufwand nacheinander behandelt werden können.

Diese Aufgabe wird gemäß der Erfindung dadurch gelöst, daß das Gaszuführrohr als Innenleiter eines koaxialen Wellenleiters elektrisch leitendes Material aufweist und daß ein zusätzlicher, elektrisch leitender, im wesentlichen zylindermantelförmiger Hohlleitereinsatz in dem koaxialen Wellenleiter angebracht ist, welcher das Gaszuführrohr mit Abstand koaxial umgibt. Die gesamte Einkoppelanordnung erstreckt sich von einer ersten Seite, die man zur besseren Vorstellung zum Beispiel als die vordere oder untere Seite bezeichnen kann, zu einer gegenüberliegenden zweiten Seite, welche dann bei der Anordnung entsprechend hinten bzw. oben vorgesehen ist. Es ergibt sich bei dieser Anordnung damit eine Mittelachse, die sich von der ersten zu der zweiten Seite, d.h. also von vorn nach hinten oder von unten nach oben erstreckt. Parallel zu dieser Achse verläuft das Gaszuführrohr und wird erfindungsgemäß als Innenleiter des koaxialen Wellenleiters verwendet. Deshalb erstreckt sich dieses Gaszuführrohr von der ersten Seite, d.h. von vorn und unten entlang der Achse nach oben in diesen koaxialen Wellenleiter. Gegenüber, d.h. auf der oberen zweiten Seite der Anordnung, ist die Mikrowelleneinkoppeleinrichtung vorgesehen. Der zu behandelnde Hohlkörper umgreift mit Abstand das Gaszuführrohr, so daß sich die gedachte Achse der Anordnung auch durch den Hohlkörper erstreckt.

Zwar wird im Falle der Erfindung wie auch bei der bekannten Anordnung ein Prozeßgas mit Hilfe des Gaszuführrohres in das Innere des Hohlkörpers eingeführt, und das Prozeßgas wird durch die eingekoppelte Mikrowellenenergie in den Plasmazustand aktiviert. Im bekannten Falle ist die Einkoppelrichtung aber senkrecht zu der erwähnten Achse durch den Hohlkörper, so daß sich bei der Erfindung wesentlich günstigere Voraussetzungen für den Formatwechsel des Hohlkörpers ergeben.

Bei Einführen eines Hohlkörpers mit anderem Format, d.h. anderer Größe, anderer Gestalt usw., ändert sich die Impedanz der Einkoppelanordnung mit dem Ergebnis, daß sich eine unerwünschte Reflexion der Mikrowellenenergie ergibt und für die Aktivierung in den Plasmazustand nur ein zu kleiner Anteil der eingespeisten Mikrowellenenergie zur Verfügung steht. Die Änderung der Impedanz kann man nun durch Änderung der die Behandlungskammer umgebenden Wellenleiter einrichten. Es müßte zum Beispiel der Abstand zwischen dem Gaszuführrohr und dem koaxialen Wellenleiter verändert werden. Eine derartige aufwendige Veränderung wird aber überraschend durch die zusätzliche Maßnahme der Erfindung vermieden, daß nämlich der zusätzliche, elektrisch leitende Hohlleitereinsatz im Abstand um das Gaszuführrohr angeordnet wird. Der Hohlleitereinsatz hat einen kleineren Durchmesser als der Außenleiter, d.h. der koaxiale Wellenleiter. Der Hohlleitereinsatz ist im wesentlichen zylindermantelförmig, wobei mit gewissen Abwandlungen alle ähnlichen Gestaltungen denkbar sind, zum Beispiel leicht konische Ausführungen, unterbrochene oder durchgehende Ausführungen , Gitterform usw.. Der Hohlleitereinsatz gemäß der Erfindung verändert die Impedanz bei dem anderen Format des zweiten Hohlkörpers derart, daß sie wieder gleich erscheint wie bei dem ersten Hohlkörper, bei welchem die Anpassung für die Mikrowellenenergie optimal eingestellt war. Ersichtlich ist es wesentlich einfacher, einen Hohlleitereinsatz zusätzlich in den koaxialen Wellenleiter einzubauen, als diesen Wellenleiter selbst durch einen anderen zu ersetzen. Die Montagezeiten und -aufwendungen sind erheblich geringer. Damit können nacheinander Hohlkörper unterschiedlichen Formates behandelt werden, ohne daß die Einkoppelanordnung zeitaufwendig und kostspielig umgerüstet werden müßte.

Günstig ist es gemäß der Erfindung ferner, wenn sich an der zweiten Seite des koaxialen Wellenleiters die erste Seite eines etwa zylindrischen Hohlleiters anschließt und an dessen zweiter Seite die Mikrowelleneinkoppeleinrichtung vorgesehen ist. Durch diese Anordnung ist eine Folge von Wellenleitern gefunden worden, mit deren Hilfe die Leistung einem gemäßigten Reflexionsfaktor unterliegt. Hohlkörper ungleicher Volumina und ungleicher Gestaltung können dann in gewissem Maße ohne weitere Anpassungen oder Impedanzänderungen immer noch recht effektiv behandelt werden, zum Beispiel beschichtet werden. Es steht nämlich durch diese vorteilhafte Anordnung des Hohlleiters und des koaxialen Wellenleiters genügend Mikrowellenleistung für das Zünden und Aufrechterhalten des Plasmas zur Verfügung. Durch die Hintereinanderanordnung der zwei elektrisch unterschiedlichen Wellenleiterabschnitte werden in größerem Umfang als bislang Fehlanpassungen vermieden, und die Einkopplung der Mikrowellenleistung gelingt mit gutem Wirkungsgrad.

Zweckmäßig ist es erfindungsgemäß auch, wenn in dem sich auf der zweiten Seite der Anordnung befindenden zylindrischen Hohlleiter ein Quarzfenster angebracht ist, das sich quer zu der Längsachse der Anordnung erstreckt. Dieses Quarzfenster stellt praktisch eine Abtrennung bzw. Abdichtung dar, und dies ist gerade bei der vorstehend beschriebenen Anordnung mit den zwei Wellenleiterabschnitten nützlich und gut möglich. Die oben bereits beschriebene Achse oder Längsachse verläuft in Linie vom Gaszuführrohr zur Einkoppeleinrichtung. Das Quarzfenster erstreckt sich quer dazu und ist eine für Mikrowellen durchlässige Platte. Gase hingegen lassen sich durch die Quarzscheibe derart voneinander trennen, daß auf der einen Seite ein Vakuum erzeugt werden kann, während auf der anderen Seite Atmosphärendruck herrscht.

Besonders günstig ist es, wenn erfindungsgemäß der Hohlleitereinsatz Ausnehmungen aufweist, wenn er zum Beispiel die Form eines Gitterkorbes hat. Je nach der Gestalt und Anordnung der Ausnehmungen in dem zylindermantelförmigen Hohlleitereinsatz können die Impedanz und Feldverteilung auf spezielle Hohlkörpertypen angepaßt und verändert werden.

Die eingestrahlte Mikrowellenfrequenz liegt aus technischen Gründen bekanntermaßen zum Beispiel bei etwa 2,5 GHz fest. Damit aber ist wiederum die Art und Dimensionierung der Mikrowelleneinkopplung in den Wellenleiter praktisch festgelegt. Durch die Anordnung des neuen Hohlleitereinsatzes mit den Ausnehmungen kann man mit wenig Modifikationen beim Formatwechsel des Hohlkörpers auskommen. Die einmal gefundene gute Einkopplungsgeometrie erfordert nach dem Formatwechsel nicht aufwendige Umbauten der Wellenleiter. Die Einkoppeleinrichtung in dem zylindrischen Hohlleiter braucht nach einmaliger Optimierung nicht weiter verändert zu werden. Über die Anordnung des entsprechend auszuwählenden Hohlleitereinsatzes hinaus besteht keine Notwendigkeit für ein weiteres Abstimmen mehr. Der Hohlleitereinsatz ist bewußt im Bereich des koaxialen Wellenleiters angeordnet, so daß bei Formatwechsel die Impedanz allein durch Änderungen in dem koaxialen Abschnitt angepaßt wird.

Besonders vorteilhaft ist es, wenn erfindungsgemäß die Ausnehmungen in dem Hohlleitereinsatz parallel zueinander verlaufende Schlitze sind. Diese können mechanisch recht leicht hergestellt werden und können in unterschiedlicher Ausrichtung, Anzahl und Dichte auf dem zylindermantelförmigen Hohlleitereinsatz vorgesehen werden. Durch die Ausnehmungen und insbesondere die Schlitze wird mit besonderem Vorteil eine Modenselektion erlaubt. Bekanntlich gehört zu jeder Mode eine bestimmte spezifische Verteilung von elektrischen Strömen in der Wand des betreffenden Wellenleiters, zum Beispiel also in dem Hohlleitereinsatz. Werden diese Wandströme unterbrochen, kann sich die eine oder andere zugehörige Mode nicht ausbilden. In einem zylindrischen Hohlleiter können sich sowohl TE- als auch TM-Moden ausbreiten. Zusammen mit TM-artigen Moden bilden sich Wandströme parallel zur Zylinderachse aus, während zu allen TE-artigen Moden zirkulare Wandströme senkrecht zu dieser Achse gehören.

Wenn bei weiterer vorteilhafter Ausgestaltung die Schlitze senkrecht zur Achse des Hohlleitereinsatzes verlaufen, bei vertikal gedachter Achse der Anordnung also im wesentlichen horizontal verlaufen, dann können sich nur noch zirkulare Ströme in der Wandung des Hohlleitereinsatzes ausbilden, so daß sich folglich TE-artige Moden ausbilden.

Eine andere Ausführungsform ist erfindungsgemäß dadurch gekennzeichnet, daß die Schlitze auf dem Hohlleitereinsatz homogen verteilt angebracht sind. Bei etwa gleichmäßiger Außenform und Gestaltung des zu behandelnden Hohlleiters kann auf diese Weise die Verteilung der Intensität des elektromagnetischen Feldes im Plasma und damit das Ergebnis der Mikrowellenbehandlung vergleichmäßigt werden. Man kann ferner erfindungsgemäß die Anordnung so weiter ausgestalten, daß der Hohlleitereinsatz auf seiner einen Seite einen ersten Ring und auf der gegenüberliegenden Seite eine Gruppe von zweiten Ringen aufweist und alle Ringe durch mindestens einen zu der Achse des Hohlleitereinsatzes parallel verlaufenden Steg gehalten und miteinander verbunden sind. Es steht mitunter das Problem der Beschichtung einer Kunststoffflasche von deren Innenseite her an. Eine Flasche hat auf der Seite ihrer Öffnung einen Hals mit Haltering, gegebenenfalls mit Gewinde, so daß, auf das Volumen gesehen, eine größere Materialansammlung als im Mittelbereich vorliegt. Auch auf der anderen, nämlich der Bodenseite ist im Verhältnis zur Mitte eine größere Materialansammlung gegeben, die je nach der Gestaltung des Bodens unterschiedlich sein kann. Man kann mit dem neuen Hohlleitereinsatz gemäß der Erfindung die Konzentration der Mikrowellenenergie am Boden über den einen ersten Ring und im Bereich des Flaschenhalses (als Beispiel) über die Gruppe von zweiten Ringen an die richtigen Stellen konzentrieren mit der Folge, daß auf der inneren Wandung der Flasche oder eines anderweitigen Behälters die gewünschte Beschichtung durch das Plasma in gleichmäßiger Form erreicht wird. Die Gruppe der zweiten Ringe besteht aus 2 bis 8 oder bevorzugt 4 Ringen, die sich über einen Teil der Steglänge erstrecken, zum Beispiel über denjenigen Teil der Längserstreckung einer Flasche, in welchem sich die Flasche zum Hals und zu ihrer Öffnung hin verjüngt, wobei der Bereich der Ausgießöffnung der Flasche am Ende dieser Ringgruppe angeordnet ist.

Wenn man bei einer wiederum anderen Ausführungsform erfindungsgemäß die Schlitze parallel zu Achse des Hohlleitereinsatzes verlaufen läßt und die die Schlitze bildenden Materialteile durch wenigstens einen Ring miteinander verbunden sind, dann verlaufen die Schlitze mit anderen Worten parallel zu der Achse der Anordnung und lassen infolgedessen die Ausbildung von TM-Moden zu. Der Ring ist aus mechanischen Gründen notwendig, um die den jeweiligen Steg bildenden Materialstreifen zu halten. Andererseits kann man die Anordnung des Ringes ausnutzen, um die Mikrowellenenergie am einen oder anderen Ende oder auch an beiden Enden des zu behandelnden Hohlkörpers mit der richtigen Intensität einzuleiten.

Es ist vorstellbar, daß man die parallel zur Achse verlaufenden Materialstreifen an beiden Seiten mit einem Ring miteinander verbindet und dadurch haltert.

Es war oben bereits erwähnt worden, daß die Anordnung an der vorderen ersten Seite einen koaxialen Wellenleiter aufweist, dessen Innenleiter das metallene Gaszuführrohr ist. Es hat sich gezeigt, daß koaxiale Wellenleiter die Ausbreitung von Mikrowellenenergie in der TEM-artigen Mode erlauben. Diese Moden haben keine untere Grenzfrequenz. In einem koaxialen Wellenleiter relativ großen Durchmessers können sich Mikrowellen mit ziemlich niedrigen Frequenzen ausbreiten. Mikrowellen mit diesen Frequenzen würden in einem nicht koaxialen, sondern einem Hohlleiter desselben Durchmessers blockiert, weil dessen Grenzfrequenz zu hoch wäre. Erfindungsgemäß wird für diese Ausführungsform daher vorgeschlagen, den koaxialen Wellenleiter mit Mikrowellen mit nur TEM-artigen Moden zu betreiben. Für den Betrieb steht dann ein breiter Bereich erlaubter Frequenzen zur Verfügung. Für die Praxis ist dies wiederum mit dem Vorteil verbunden, daß man bei einem Formatwechsel von einem ersten Hohlkörper zu einem zweiten eine weniger drastische Impedanzveränderung feststellt und die erfindungsgemäße Anordnung daher Behandlungsergebnisse zufriedenstellender Qualität für beide Hohlkörper gewährleistet.

Für die Anordnung selbst bedeutet die Ausbildung der TEM-Mode, daß man in der Wahl des Durchmessers des Hohlleitereinsatzes freier ist. Dieser kann nicht allein nach elektrischen Gesichtspunkten ausgewählt werden, sondern ist auch von den Maßen des zu beschichtenden Hohlkörpers nach unten begrenzt.

Die Erfindung lehrt, daß durch eine geeignete Schlitzung der Wände des Hohlleitereinsatzes und die damit einhergehende Modenselektion eine optimale Kopplung und Feldverteilung durch Anpassung der Moden im zylindrischen Hohlleiter und im koaxialen Teil erzielt werden können.

Weitere Vorteile, Merkmale und Anwendungsmöglichkeiten der vorliegenden Erfindung ergeben sich aus der folgenden Beschreibung bevorzugter Ausführungsformen. Bei diesen zeigen:
- Figur 1: eine teilweise abgebrochene und schematisierte Querschnittsansicht durch eine Einkoppelanordnung gemäß einer ersten Ausführungsform der Erfindung,
- Figur 2: eine zweite Form eines zylindermantelförmigen Hohlleitereinsatzes in Perspektive mit horizontal verlaufenden Schlitzen,
- Figur 3: eine Seitenansicht des Hohlleitereinsatzes der Figur 2, wenn man senkrecht auf den vertikal durchgehenden Steg blickt,
- Figur 4: eine dritte Ausführungsform eines Hohlleitereinsatzes mit vertikal verlaufenden Schlitzen, in perspektivischer Darstellung,
- Figur 5: eine Seitenansicht auf den Hohlleitereinsatz der Figur 4,
- Figur 6: eine vierte Ausführungsform eines Hohlleitereinsatzes in perspektivischer Darstellung,
- Figur 7: eine Ansicht des Hohlleitereinsatzes der Figur 6 von der Seite derart, daß rechts und links jeweils ein Steg mit seiner Schmalseite zu sehen ist und die Gruppe der Ringe umgekehrt unten angeordnet ist,
- Figur 8: eine fünfte Ausführungsform eines Hohlleitereinsatzes in perspektivischer Darstellung, der ähnlich aufgebaut ist wie Figur 4, wobei jedoch an den vier mit den Pfeilen gekennzeichneten Stellen jeweils, ein Steg fehlt,
- Figur 9: eine Seitenansicht auf den Hohlleitereinsatz der Figur 8,
- Figur 10: eine sechste Ausführungsform eines Hohlleitereinsatzes in perspektivischer Darstellung und
- Figur 11: eine Seitenansicht des Hohlleitereinsatzes der Figur 9, wenn man die beiden vertikal aufragenden Stege seitlich mit ihren Schmalseiten sieht.

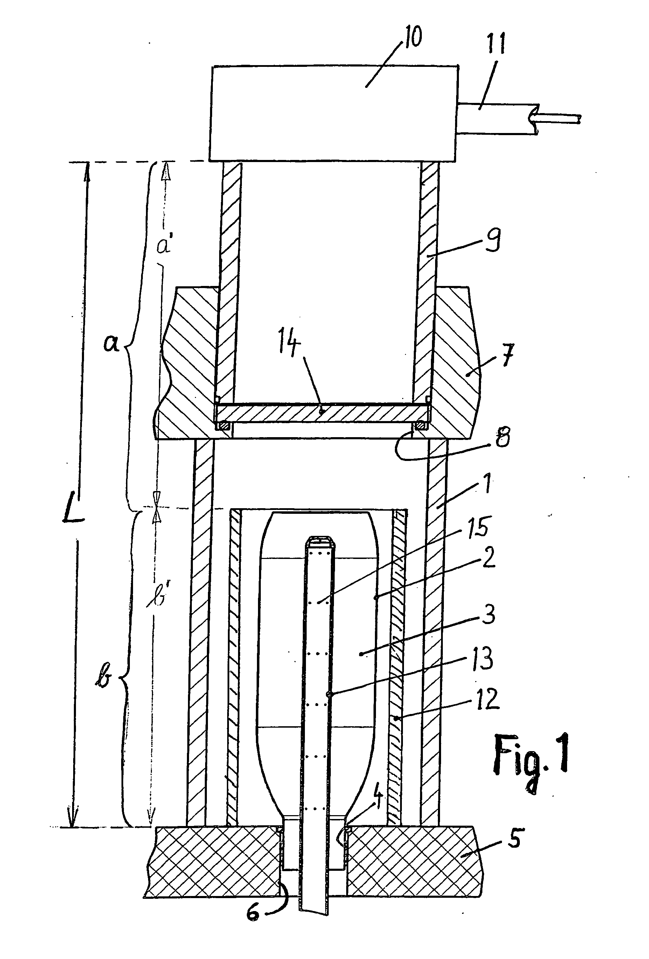

In Figur 1 befindet sich in einem Hohlraumresonator 1 ein als Kunststoffflasche ausgestalteter Hohlkörper 2. Durch diesen wird die Behandlungskammer 3 gebildet, die sich also im Inneren des Hohlkörpers 2 befindet. Dies kann zum Beispiel eine Plasma-CVD-Beschichtungskammer für die Beschichtung der Innenwand des Hohlkörpers 2 sein. Der Hohlkörper 2 ist nur an seinem vorderen unteren Ende, nämlich an seiner sogenannten ersten Seite, über einen Hals 4 offen. Oben und hinten ist der Hohlkörper ebenso geschlossen wie an den Seiten. Der Hohlkörper 2 wird über seinen Hals 4 von einer Behälterträgerplatte 5 gehaltert. Bei der Ausführungsform der Figur 1 ist die Behälterträgerplatte 5 rechts und links abgebrochen gezeigt. Man kann sich diese Platte länger ausgedehnt vorstellen, so daß man viele solche Einheiten nebeneinander an der Behälterträgerplatte 5 haltern kann. Jeweils ein Loch 6 in der Behälterträgerplatte 5 dient der Aufnahme des jeweiligen Halses 4.

Nach oben hinten zu der zweiten Seite hin ist im Abstand vom Boden des Hohlkörpers 2 eine etwa horizontal und parallel zur Behälterträgerplatte 5 verlaufende Trennwand 7 an dem Hohlraumresonator 1 befestigt. Die Längsachse der Einkoppelanordnung ist zwar in den Figuren nicht gezeigt, sie verläuft aber in jeder Einheit, von welcher in Figur 1 eine einzige dargestellt ist, senkrecht zu der Behälterträgerplatte 5 und auch senkrecht zu der Trennwand 7, also von der ersten Seite unten vorn zu der zweiten Seite oben hinten, in den Figuren etwa vertikal. In der Trennwand 7 ist über jedem Hohlkörper 2 ein Loch 8 zur Aufnahme eines zylindermantelförmigen Gehäuses 9 vorgesehen, welches nach hinten oben durch eine sogenannte Mikrowelleneinkoppeleinrichtung 10 abgeschlossen ist.

Rechts von dieser Mikrowelleneinkoppeleinrichtung 10 ist in Figur 1 eine Mikrowellenzuführung 11 befestigt, die nach rechts sowie nach außerhalb des Gehäuses 9 ragt. Diese Mikrowellenzuführung 11 ist typischerweise ein Koaxialkabel oder ein koaxialer Wellenleiter und speist die Mikrowelleneinkoppeleinrichtung 10. Mit deren Hilfe kann auf unterschiedlichste Weise die Mikrowellenenergie in den Hohlraumresonator 1 eingekoppelt werden, zum Beispiel über eine hier nicht dargestellte Antenne.

Insgesamt erstreckt sich der Raum mit den Wellenleitern von der ersten zur zweiten Seite, d.h. von vorn nach hinten (in den Figuren von unten nach oben) von der inneren Oberfläche der Behälterträgerplatte 5 bis zu der inneren Oberfläche der Mikrowelleneinkoppeleinrichtung 10. Dieser mit Mikrowellen beaufschlagte Raum hat die Gesamtlänge L. Die Anordnung dieses im wesentlichen zylindrischen Aufbaues ist in solcher Art vorgesehen, daß man elektrisch gesehen auf der zweiten Seite, in der Figur 1 also oben, in dem Bereich a einen etwa zylindrischen Hohlleiter hat, welcher keinen Innenleiter aufweist. Auf der vorderen ersten Seite (in den Figuren unten) ist im Bereich b ein koaxialer Wellenleiter vorgesehen. Dieser hat einen als Gaszuführrohr 13 ausgestalteten Innenleiter.

Am vorderen unteren Ende, d.h. an der ersten Seite des zylindermantelförmigen Gehäuses ist - noch in der Trennwand 7 angeordnet - ein Quarzfenster 14 befestigt, durch welches der Raum in dem Hohlraumresonator 1 von dem Raum im Gehäuse 9 gasdicht derart abtrennbar ist, daß im Gehäuse 9 der Druck der enthaltenen Gase anders sein kann als in dem Hohlraumresonator 1.

Von der ersten Seite vorn und unten in Figur 1 kann in nicht dargestellter Weise ein Gasgemisch durch das Gaszuführrohr 13 und seine darin befindlichen Löcher 15 in die Behandlungskammer 3 eingeführt werden. Dieses Gasgemisch für eine Plasmabildung verbleibt innerhalb des Volumens des Hohlkörpers 2, verbleibt also in der Behandlungskammer 3. Der sogenannte Plasmabereich liegt dann im wesentlichen innerhalb des vorderen unteren Bereiches b in dem Hohlraumresonator 1.

Im Bereich b des Hohlraumresonators 1 befindet sich also der koaxiale Wellenleiter, in welchem zusätzlich ein elektrisch leitender, im wesentlichen zylindermantelförmiger Hohlleitereinsatz 12 angebracht ist. Dieser Hohlleitereinsatz 12 umgibt das Gaszuführrohr 13 im Abstand und befinden sich koaxial zu diesem und zu dem Hohlraumresonator 1. Der Hohlleitereinsatz 12 der Figur 1 kann zum Beispiel ein mit wenigen hier nicht dargestellten Ausnehmungen versehener Zylindermantel, gegebenenfalls auch in Gitterform sein.

Der Bereich a wird durch den Abstand zwischen der oben an seiner zweiten Seite am Boden des Hohlkörpers 2 befindlichen Ebene und der Innenseite der Mikrowelleneinkoppeleinrichtung 10 bestimmt. Der Abstand dieser beiden in Figur 1 horizontal verlaufenden Ebenen beträgt also a', während die Länge b', des Bereiches b durch den Abstand zwischen der inneren ebenen Fläche der Behälterträgerplatte 5 und dem Boden des Hohlkörpers 2 bestimmt wird. Die Gesamtlänge der Einkoppelanordnung L = a' + b'.

Einrichtungen zur Speisung des Hohlkörpers 2 mit Prozeßgas sind ebenso wenig gezeigt wie Einrichtungen zur Evakuierung der betreffenden Räume, in welche frisches Prozeßgas zugeführt und verbrauchtes Gas abgezogen wird. Nach Füllen der Behandlungskammer 3 mit Prozeßgas wird die Mikrowellenquelle eingeschaltet und das Prozeßgas in den Plasmazustand aktiviert. Nach der Beschichtung der Innenwandung des Hohlkörpers 2 wird das verbrauchte Gas abgezogen.

Um das Aktivieren des Prozeßgases in den Plasmazustand möglichst intensiv durchzuführen, wird je nach der Gestalt des zu beschichtenden Hohlkörpers 2 ein anderer Hohlleitereinsatz 12 eingesetzt.

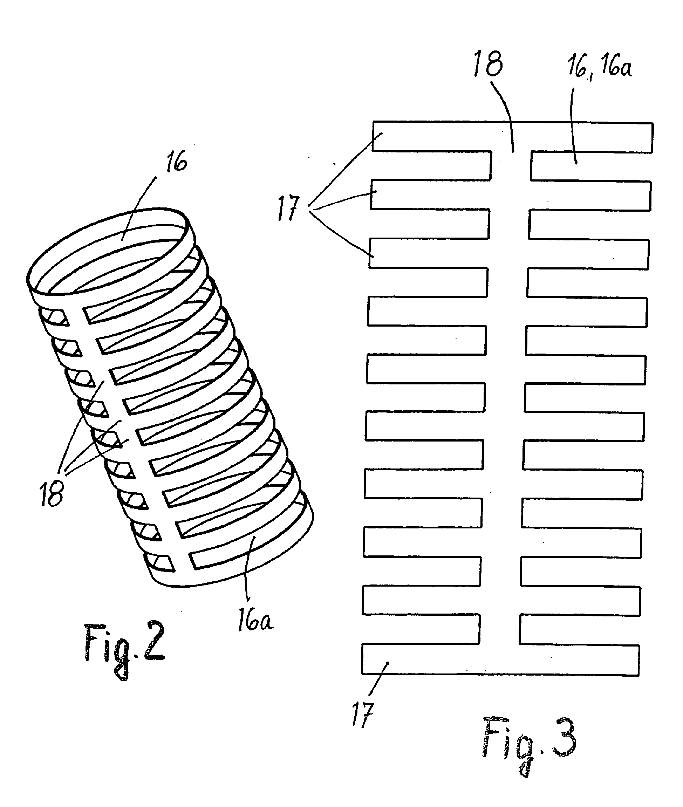

Zum Beispiel ist in Figur 2 eine zweite Ausführungsform eines solchen Hohlleitereinsatzes 12 dargestellt. In allen Figuren 2 bis 10 sind Hohlleitereinsätze 12 gezeigt, weshalb die Gesamtheit der jeweiligen Darstellung nicht wiederholt mit der Bezugszahl 12 versehen ist. Die Hohlleiter aller Ausführungsformen nach den Figuren 2 bis 10 weisen Ausnehmungen 16 auf. Bei den Figuren 2 und 3 bestehen die Ausnehmungen 16 aus parallel zueinander verlaufenden Schlitzen 16a. Sie verlaufen homogen verteilt über die ganze Höhe des Hohlleitereinsatzes 12 und erstrecken sich senkrecht zu der Längsmittelachse des Hohlleitereinsatzes 12. Das Material zwischen den Schlitzen 16a wird durch Ringe 17 gebildet, welche durch einen vertikal und parallel zu der Längsmittelachse verlaufenden Steg 18 gehalten und miteinander verbunden sind.

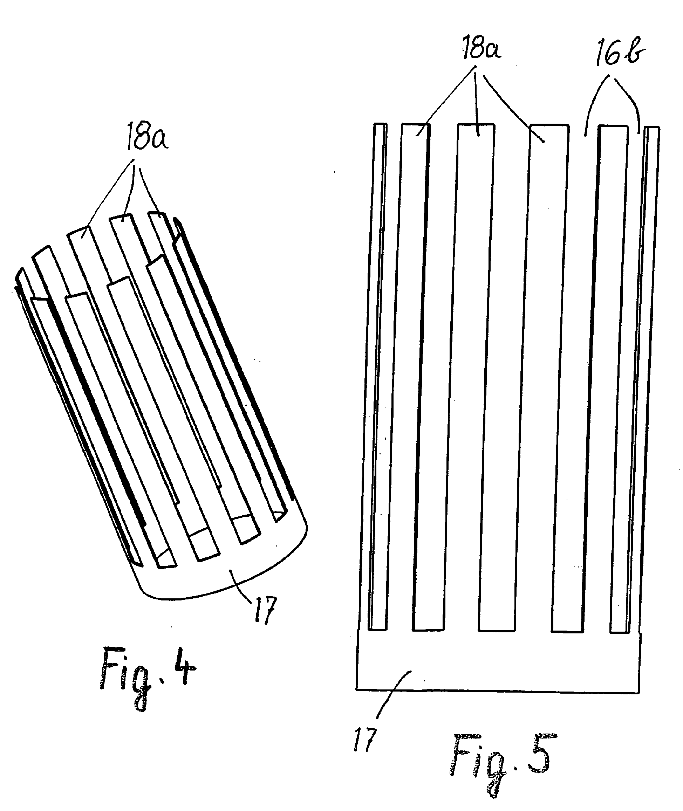

Der Hohlleitereinsatz 12 nach den Figuren 4 und 5 weist nur einen Ring 17 an einem Ende auf, von welchem eine Vielzahl von Stegen 18a aufragen. Diese verlaufen alle parallel und im Abstand der Schlitze 16b zueinander. Die Schlitze 16b und auch die Stege 18a liegen also parallel zur Achse des Hohlleitereinsatzes 12.

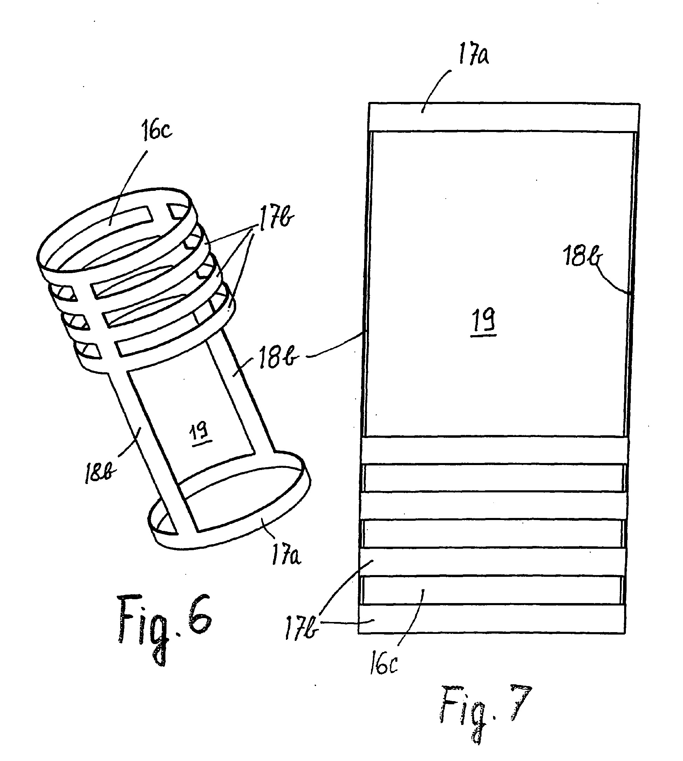

Bei der Ausführungsform nach den Figuren 6 und 7 hat der Hohlleitereinsatz 12 auf seiner einen Seite (in Figur 6 unten und in Figur 7 oben) einen ersten Ring 17a und auf der gegenüberliegenden Seite eine Gruppe von zweiten Ringen 17b. An dem ersten Ring 17a sind an diametral gegenüberliegenden Seiten zwei Stege 18b angesetzt, die sich parallel zur Längsmittelachse des Hohlleitereinsatzes 12 zu der gegenüberliegenden Seite und damit zu der Gruppe der zweiten Ringe 12 erstrecken. Sowohl die Ringe 17a als auch die zweiten Ringe 17b werden durch diese beiden Stege 18b gehalten und miteinander verbunden. Zwischen dem einzelnen ersten Ring 17a und der im Abstand davon angeordneten Gruppe von zweiten Ringen 17b ergibt sich ein freier Raum 19.

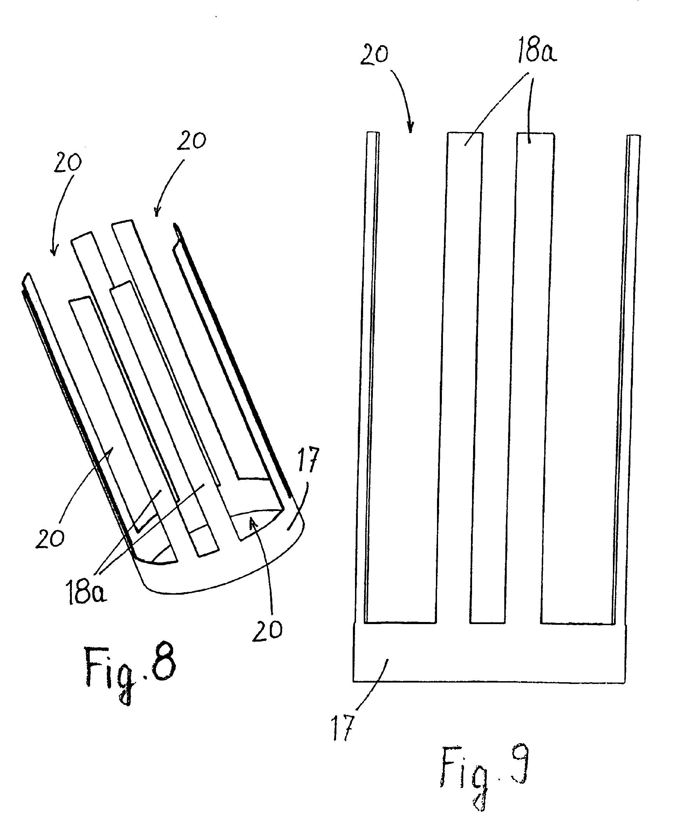

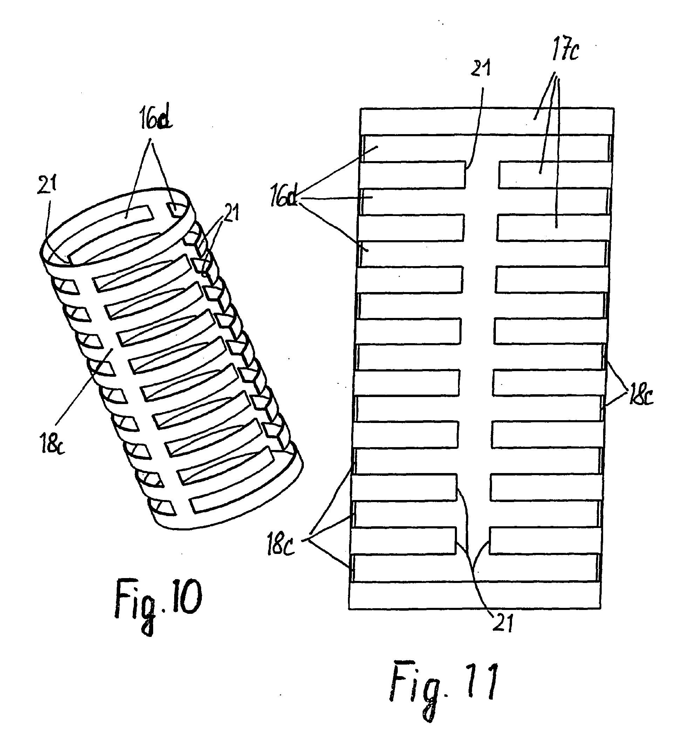

Der Hohlleitereinsatz 12 nach den Figuren 8 und 9 ist ähnlich aufgebaut wie der nach den Figuren 4 und 5, wobei nur an den mit den Pfeilen gekennzeichneten vier Stellen Lücken 20 gebildet sind. Zwischen den Lücken befinden sich also jeweils Paare von Stegen 18a. Diese vier Paare von Stegen 18a werden durch den Ring 17 an der einen Seite, die in den Figuren 8 und 9 unten gezeigt ist, zusammengehalten.

Die Ausführungsform nach den Figuren 10 und 11 hat eine gewisse Ähnlichkeit mit der der Figuren 2 und 3, wobei jedoch senkrecht zu der Längsmittelachse des Hohlleitereinsatzes 12 verlaufenden Schlitze 16d durch zwei parallel zur Längsmittelachse des Hohlleitereinsatzes 12 verlaufende Stege 18c gehalten werden. Die Ringe 17c können daher bis auf den obersten und den untersten Ring unterbrochen sein, wie an den Stellen 21 gezeigt ist.

### Bezugszeichenliste

- 1: Hohlraumresonator
- 2: Hohlkörper
- 3: Behandlungskammer
- 4: Hals
- 5: Behälterträgerplatte
- 6: Loch
- 7: Trennwand
- 8: Loch
- 9: Gehäuse
- 10: Mikrowelleneinkoppeleinrichtung
- 11: Mikrowellenzuführung
- 12: Hohlleitereinsatz
- 13: Gaszuführrohr
- 14: Quarzfenster
- 15: Löcher
- 16: Ausnehmungen
- 16 a, b, c, d: Schlitze
- 17 a,b,c,: Ringe
- 18 a,b,c,: Stege
- 19: Lücke
- 20: Lücken
- 21: Lückenstelle

- L: Gesamtlänge der Einkoppelanordnung
- a: oberer Bereich des Hohlraumresonators
- b: unterer Bereich des Hohlraumresonators
- a': Länge des oberen Bereiches des Hohlraumresonators
- b': Länge des unteren Bereiches des Hohlraumresonators

## Patentansprüche

1. Anordnung zum Einkoppeln von Mikrowellenenergie in einen Hohlkörper (2), welcher die Behandlungskammer (3) bildet, insbesondere eine Plasma-CVD-Beschichtungskammer für die Beschichtung der Innenwand eines Hohlkörpers (2), mit einer Mikrowellenquelle, einer Mikrowelleneinkoppeleinrichtung (10), einem Mikrowellenleiter (1, 9) und einem Gaszuführrohr 13), durch welches Prozeßgas in den Hohlkörper (2) einführbar und durch die eingekoppelte Mikrowellenenergie in den Plasmazustand aktivierbar ist und welches sich von einer ersten Seite koaxial in den Hohlkörper (2) erstreckt, während sich die Mikrowelleneinkoppeleinrichtung (10) auf der gegenüberliegenden zweiten Seite befindet, **dadurch gekennzeichnet, daß** das Gaszuführrohr (13) als Innenleiter eines koaxialen Wellenleiters (1) elektrisch leitendes Material aufweist und daß ein zusätzlicher, elektrisch leitender, im wesentlichen zylindermantelförmiger Hohlleitereinsatz (12) in dem koaxialen Wellenleiter angebracht ist, welcher das Gaszuführrohr (13) im Abstand koaxial umgibt.

2. Anordnung nach Anspruch 1, **dadurch gekennzeichnet, daß** sich an der zweiten Seite des koaxialen Wellenleiters (1) die erste Seite eines etwa zylindrischen Hohlleiters (1, 9) anschließt und an dessen zweiter Seite die Mikrowelfeneinkoppeleinrichtung (10) vorgesehen ist

3. Anordnung nach Anspruch 1 oder 2, **dadurch gekennzeichnet, daß** in dem sich auf der zweiten Seite der Anordnung befindenden zylindrischen Hohlleiter (9) ein Quarzfenster (14) angebracht ist, das sich quer zu der Längsachse der Anordnung erstreckt.

4. Anordnung nach einem der Ansprüche 1 bis 3, **dadurch gekennzeichnet, daß** der Hohlleitereinsatz (12) Ausnehmungen aufweist.

5. Anordnung nach einem der Ansprüche 1 bis 4, **dadurch gekennzeichnet, daß** die Ausnehmungen (16) in dem Hohlleitereinsatz (12) parallel zueinander verlaufende Schlitze sind.

6. Anordnung nach einem der Ansprüche 1 bis 5, **dadurch gekennzeichnet, daß** die Schlitze (16a) senkrecht zur Achse des Hohlleitereinsatzes (12) verlaufen.

7. Anordnung nach einem der Ansprüche 1 bis 6, **dadurch gekennzeichnet, daß** die Schlitze (16a) auf dem Hohlleitereinsatz (12) homogen verteilt angebracht sind.

8. Anordnung nach einem der Ansprüche 1 bis 7, **dadurch gekennzeichnet, daß** der Hohlleitereinsatz (12) auf seiner einen Seite einen ersten Ring (17a) und auf der gegenüberliegenden Seite eine Gruppe von zweiten Ringen (17b) aufweist und alle Ringe durch mindestens einen zu der Achse des Hohlleitereinsatzes (12) parallel verlaufenden Steg (18b) gehalten und miteinander verbunden sind.

9. Anordnung nach einem der Ansprüche 1 bis 8, **dadurch gekennzeichnet, daß** die Schlitze (16b) parallel zur Achse des Hohlleitereinsatzes (12) verlaufen und das Material zwischen den Schlitzen (16b) durch wenigstens einen Ring (17) zusammengehalten ist.

## Claims

1. An arrangement for coupling microwave energy into a hollow body (2) forming treatment chamber (3), in particular into a plasma CVD coating chamber for coating the internal wall of a hollow body (2), comprising a microwave source, a microwave coupling-in device (10), a microwave guide (1, 9) and a gas feed tube (13), through which process gas can be introduced into the hollow body (2) and can be activated into the plasma state by the coupled-in microwave energy, and which gas feed tube (13) extends coaxially from a first side into said hollow body (2) while the microwave coupling-in device (10) is arranged on the opposite second side, **characterised in that** the gas feed tube (13) as an internal conductor of a coaxial waveguide (1) comprises electrically conducting material and that an additional, electrically conducting, substantially cylindrical hollow conductor insert (12) is disposed in the coaxial waveguide, which surrounds the gas feed tube (13) at a spacing in coaxial relationship.

2. An arrangement according to claim 1 **characterised in that** the second side of the coaxial waveguide (1) is adjoined by the first side of an approximately cylindrical hollow conductor (1, 9) and provided at its second side is the microwave coupling-in device (10).

3. An arrangement according to claim 1 or claim 2 **characterised in that** disposed in the cylindrical hollow conductor (9) which is on the second side of the arrangement is a quartz window (14) which extends transversely with respect to the longitudinal axis of the arrangement.

4. An arrangement according to one of claims 1 to 3 **characterised in that** the hollow conductor insert (12) has openings.

5. An arrangement according to one of claims 1 to 4 **characterised in that** the openings (16) in the hollow conductor insert (12) are slots extending in mutually parallel relationship.

6. An arrangement according to one of claims. 1 to 5 **characterised in that** the slots (16a) extend perpendicularly to the axis of the hollow conductor insert (12).

7. An arrangement according to one of claims 1 to 6 **characterised in that** the slots (lea) are disposed homogeneously distributed on the hollow conductor insert (12).

8. An arrangement according to one of claims 1 to 7 **characterised in that** the hollow conductor insert (12) has on its one side a first ring (17a) and on the opposite side a group of second rings (17b) and all rings are held and connected together by at least one bar (18b) extending in parallel relationship with the axis of the hollow conductor insert (12).

9. An arrangement according to one of claims 1 to 8 **characterised in that** the slots (16b) extend in parallel relationship with the axis of the hollow conductor insert (12) and the material is held together between the slots (16b) by at least one ring (17)

## Revendications

1. Système permettant d'injecter de l'énergie micro-ondes dans un corps creux (2) qui forme une chambre de réaction (3), notamment une chambre de revêtement CVD à plasma destinée à revêtir la paroi intérieure d'un corps creux (2), ledit dispositif comportant une source de micro-ondes, un dispositif d'injection de micro-ondes (10), un guide de micro-ondes (1, 9) et un tube d'amenée de gaz (13) qui permet d'introduire du gaz de traitement dans le corps creux (2) et de l'activer à l'état de plasma par l'énergie micro-ondes injectée et qui s'étend coaxialement, depuis un premier côté, dans le corps creux (2) tandis que le dispositif d'injection de micro-ondes (10) se trouve du deuxième côté opposé, **caractérisé en ce que** le tube d'amenée de gaz (13) est, en tant que conducteur interne d'un guide d'onde coaxial (1), en un matériau électriquement conducteur et **en ce qu'**un élément rapporté de conducteur creux (12) supplémentaire, électriquement conducteur et se présentant sous la forme d'une enveloppe cylindrique, est monté dans le guide d'onde coaxial et entoure coaxialement le tube d'amenée de gaz (13) à distance de celui-ci.

2. Système selon la revendication 1, **caractérisé en ce que** le premier côté d'un conducteur creux (1, 9) sensiblement cylindrique est raccordé au deuxième côté du guide d'onde coaxial (1) et le dispositif d'injection de micro-ondes (10) est disposé au niveau du deuxième côté du conducteur creux.

3. Système selon la revendication 1 ou 2, **caractérisé en ce qu'**une fenêtre de quartz (14), qui s'étend transversalement à l'axe longitudinal du système, est montée dans le conducteur creux cylindrique (9) se trouvant au niveau du deuxième côté du système.

4. Système selon l'une des revendications 1 à 3, **caractérisé en ce que** l'élément rapporté de conducteur creux (12) comporte des évidements.

5. Système selon l'une des revendications 1 à 4, **caractérisé en ce que** des évidements (16) ménagés dans l'élément rapporté de conducteur creux (12) sont des fentes s'étendant parallèlement l'une à l'autre.

6. Système selon l'une des revendications 1 à 5, **caractérisé en ce que** les fentes (16a) s'étendent perpendiculairement à l'axe de l'élément rapporté de conducteur creux (12).

7. Système selon l'une des revendications 1 à 6, **caractérisé en ce que** les fentes (16a) sont ménagées en étant réparties uniformément sur l'élément rapporté de conducteur creux (12).

8. Système selon l'une des revendications 1 à 7, **caractérisé en ce que** l'élément rapporté de conducteur creux (12) comporte sur l'un des côtés une première bague (17a) et du côté opposé un groupe de deuxièmes bagues (17b) et toutes les bagues sont reliées et sont maintenues par au moins une nervure (18b) s'étendant parallèlement à l'axe de l'élément rapporté de conducteur creux (12).

9. Système selon l'une des revendications 1 à 8, **caractérisé en ce que** les fentes (16b) s'étendent parallèlement à l'axe de l'élément rapporté de conducteur creux (12) et le matériau situé entre les fentes (16b) est maintenu par au moins une bague (17).
